# EUROPÄISCHE PATENTSCHRIFT

(11) **EP 4 176 312 B1**
(45) Veröffentlichungstag und Bekanntmachung des Hinweises auf die Patenterteilung: **07.08.2024**
(21) Anmeldenummer: 20737007.3
(22) Anmeldetag: 06.07.2020
(51) Int. Cl.: G03F 7/20, G03F 7/095

(54) **VERFAHREN UND VORRICHTUNG ZUR BELICHTUNG EINER PHOTOSENSITIVEN BESCHICHTUNG**
METHOD AND DEVICE FOR EXPOSING A PHOTOSENSITIVE COATING
PROCÉDÉ ET DISPOSITIF D'EXPOSITION D'UN REVÊTEMENT PHOTOSENSIBLE

(43) Veröffentlichungstag der Anmeldung: 10.05.2023
(73) Patentinhaber: EV Group E. Thallner GmbH, 4782 St. Florian am Inn (AT)
(72) Erfinder: THALLNER, Bernhard, 4782 St. Florian am Inn (AT); POVAZAY, Boris, 4782 St. Florian am Inn (AT); ZENGER, Tobias, 4782 St. Florian am Inn (AT); UHRMANN, Thomas, 4782 St. Florian am Inn (AT)
(74) Vertreter: Schneider, Sascha
(86) Internationale Anmeldenummer: PCT/EP2020/068996
(87) Internationale Veröffentlichungsnummer: WO 2022/008031

(56) Entgegenhaltungen:
- DE-A1- 102016 217 929
- US-A1- 2019 287 795

## Beschreibung

Die Erfindung betrifft ein Verfahren und eine Vorrichtung zur Belichtung einer photosensitiven Beschichtung.

Die Photolithographie ist eine der wichtigsten Methoden in der Halbleiterindustrie, um ein Material zu strukturieren. Die Photolithographie wird im Stand der Technik vorwiegend mit Hilfe von Masken durchgeführt. DE102016217929A1 offenbart ein Projektionsbelichtungsverfahren zur Belichtung eines im Bereich einer Bildebene eines Projektionsobjektivs angeordneten Substrats. US2019287795A1 offenbart ein Verfahren, mit dem ein reproduzierbares CD-Variationsmuster abgemildert oder korrigiert werden kann, um gewünschte CDs aus Mikrofabrikationsstrukturierungsprozessen zu erhalten.

Die Maskenherstellung ist allerdings auch das größte Problem der maskenbasierten Photolithographie. Eine Maske muss durch sehr teure und aufwendige Herstellverfahren erzeugt werden. Dabei greift man auf Elektronenstrahllithographie zurück. Des Weiteren müssen für die Herstellung komplexer funktionaler Bauteile mehrere Masken hergestellt werden. Die Kosten für die Herstellung aller Masken für nur einen Mikrochip liegen dabei nicht selten im Millionen Euro Bereich.

Im Stand der Technik wurde daher in den letzten Jahren ein alternatives Verfahren entwickelt, bei dem ein Substrat nicht vollflächig, sondern nur abschnittsweise mit Hilfe einer digital kontrollierten, Abtastung, z.B. eines schaltbaren Feldes aus Spiegeln, belichtet wird. Die Spiegel des Spiegelfeldes, eine sogenannte digitale Mikrospiegel-Einheit (engl.: digital micromirror device, DMD), können einzeln, insbesondere hochfrequent, programmiert werden und erlauben damit die punktgenaue, beliebig ansprechbare strukturierte Bestrahlung eines zu belichtenden Abschnitts. Gleichzeitig wird eine Relativbewegung zwischen dem Substrat und dem optischen System, zu dem das DMD gehört, durchgeführt, was eine Belichtung der gesamten Substratoberfläche gestattet. Stand der Technik ist aus WO2018 113917A1, WO2018113918A1 und WO2019242840A1 bekannt.

Durch die Verwendung eines DMD kann eine photolithographische Schicht mit einem Muster, einem sogenannten Layout, belichtet werden. An jeder Stelle, an der die Schicht mit den Photonen einer wohl definierten Wellenlänge beschossen wird, erfolgt eine indirekte oder direkte chemische Reaktion der photolithographischen Schicht. Weitere Verfahrensschritte, insbesondere ein Entwicklungsschritt, führen zu einer Verfestigung des sogenannten Layouts.

In der Offenbarung wird immer von einem DMD als exemplarisches Beispiel gesprochen. Anstatt des DMDs können aber allgemeine, insbesondere auch transmissive, strukturierende Elemente verwendet werden. Transmissive optische Elemente sind vor allem für Stepper von Bedeutung. Sie unterscheiden sich von einem DMD dahingehend, dass eine ortsaufgelöste Strukturierung nicht durch Spiegel, sondern durch, insbesondere schaltbare, Aperturen bewerkstelligt wird. Auf die genaue Ausführungsform eines solchen Elements wird in der Druckschrift nicht näher eingegangen.

Stattdessen wird ein DMD als beispielhaftes optisches Element zur programmierbaren, ortsaufgelösten Belichtung beschrieben.

Mit Hilfe der genannten Verfahren ist man bereits heute in der Lage, unterschiedlichste 2D Strukturen, d.h. Strukturen innerhalb einer Ebene, oder in einer einzelnen Schicht, die in der Höher variiert, z.B. als oberste Lage auf einer Struktur mit unterschiedlicher Topografie (2,5D), zu erzeugen.

Vor allem der Aufbau von 2.5D bzw. 3D Strukturen mit komplexer, in der Strahlrichtung veränderlicher Geometrie, insbesondere überdachte konkave Hohlräume, können mit Vorrichtungen und Verfahrens des Stands der Technik nicht in einem einzigen Belichtungsprozess hergestellt werden.

Sehr wohl ist es möglich, 2.5D und 3D Strukturen durch wiederholte Anwendung bekannter Verfahren herzustellen. So wäre es möglich, eine erste Schicht auf einem Substrat aufzubringen, diese nach Positionierung des Bildes zu belichten, danach zu entwickeln, wobei das Substrat je nach Belichtung und Polarität des Lacks chemisch verfestigt oder aufgelöst wird und das Substrat erneut mit einer weiteren Schicht zu beschichten, erneut zu belichten und zu entwickeln. Diese Schritte können beliebig oft, für eine entsprechende Anzahl von gewünschten Schichten und damit gestapelten Layouts wiederholt werden.

Es ist offensichtlich, dass für die Entwicklung einer jeden Schicht alle genannten Verfahrensschritte durchgeführt werden müssen, was zu einem sehr großen Aufwand und damit zu hohen Kosten führt. Des Weiteren steigt mit jedem zusätzlichen Verfahrensschritt die Fehlerwahrscheinlichkeit für jede mögliche Fehlerart. Speziell die korrekte laterale Lage während der Belichtung ist ein fehlerempfindlicher Schritt, der zu einem akkumulierten Qualitätsverlust führen kann.

Es ist daher die Aufgabe der vorliegenden Erfindung, die Nachteile des Stands der Technik zu beseitigen oder signifikant zu reduzieren. Insbesondere zielt sie darauf ab, die Belichtung schneller und einfacher durchzuführen sowie die Fehler aller Art zu reduzieren.

Die Aufgabe wird mit dem Gegenstand der nebengeordneten Ansprüche gelöst. Vorteilhafte Weiterbildungen der Erfindung sind in den Unteransprüchen angegeben.

Die Erfindung betrifft ein Verfahren zur Belichtung einer photosensitiven Beschichtung, aufweisend mindestens einen ersten photosensitiven Bereich und einen zweiten photosensitiven Bereich, wobei der erste Bereich auf Photonen einer ersten Wellenlänge reagiert und der zweite, insbesondere den ersten Bereich überlappende, Bereich auf Photonen einer zweiten Wellenlänge reagiert, wobei die erste Wellenlänge von der zweiten Wellenlänge verschieden ist, wobei das Verfahren die folgenden Schritte, insbesondere den folgenden Ablauf, aufweist:
- Belichtung der Beschichtung mit den Photonen der ersten Wellenlänge,
- Belichtung der Beschichtung mit den Photonen der zweiten Wellenlänge.

Im weiteren Verlauf des Textes werden die photosensitiven Bereiche nur mehr als Bereiche bezeichnet.

Die Erfindung betrifft weiterhin eine Vorrichtung zur Belichtung einer photosensitiven Beschichtung, aufweisend mindestens einen ersten photosensitiven Bereich und einen zweiten photosensitiven Bereich, wobei der erste photosensitive Bereich auf Photonen einer ersten Wellenlänge reagiert und der zweite photosensitive Bereich auf Photonen einer zweiten Wellenlänge reagiert, wobei die erste Wellenlänge von der zweiten Wellenlänge verschieden ist, aufweisend eine Strahlungseinrichtung zur Belichtung der Beschichtung mit den Photonen der ersten Wellenlänge und zur Belichtung der Beschichtung mit den Photonen der zweiten Wellenlänge.

Erfindungsgemäß erfolgt keine Fokussierung der Photonen auf die photosensitiven Bereiche.Der Kern der Erfindung besteht insbesondere darin, dass eine individuelle Fokussierung der Photonen auf den einzelnen photosensitiven Bereich nicht notwendig ist, da beide Bereiche typischerweise in dünnen, sehr nahe aneinanderliegenden Schichten, innerhalb der Schärfentiefe der Projektion aufgetragen wurden. Die Photonen der jeweiligen Wellenlänge können vorteilhaft die photosensitive Beschichtung durchleuchten, erzeugen aber nur in jenem Bereich eine photochemische Reaktion, in dem das Material auf die Photonen der entsprechenden Wellenlänge reagiert.

Bevorzugt ist vorgesehen, dass die Beschichtung durch eine dynamisch steuerbare Einrichtung, insbesondere durch eine digitale Mikrospiegeleinheit, belichtet wird bzw. dass die Vorrichtung eine dynamisch steuerbare Einrichtung, insbesondere eine digitale Mikrospiegeleinheit, zur Belichtung der Beschichtung aufweist.

Bevorzugt ist weiterhin vorgesehen, dass die Beschichtung durch mindestens eine Maske belichtet wird bzw. dass die Vorrichtung mindestens eine Maske zur Belichtung der Beschichtung aufweist.

Bevorzugt ist weiterhin vorgesehen, dass die Belichtung der Beschichtung mit den Photonen der ersten Wellenlänge nur im ersten Bereich eine photochemische Reaktion erzeugt und die Belichtung der Beschichtung mit den Photonen der zweiten Wellenlänge nur im zweiten Bereich eine photochemische Reaktion erzeugt.

Bevorzugt ist weiterhin vorgesehen, dass die Beschichtung ortsaufgelöst und/oder punktweise, insbesondere mittels Strahlenbündeln, belichtet wird bzw. belichtbar ist.

Bevorzugt ist weiterhin vorgesehen, dass die Beschichtung durch eine individuell steuerbare Photonenquelle belichtet wird, wobei die Wellenlänge und/oder die Dosis der Photonen eingestellt wird/werden bzw. einstellbar ist/sind.

Bevorzugt ist weiterhin vorgesehen, dass die Beschichtung durch Einstellung eines Filters vor einer breitbandigen Photonenquelle belichtet wird, wobei die Wellenlänge und/oder die Dosis der Photonen eingestellt wird/werden bzw. einstellbar ist/sind.

Bevorzugt ist weiterhin vorgesehen, dass nacheinander unterschiedliche Tiefenbereiche der Beschichtung reagieren.

Bevorzugt ist weiterhin vorgesehen, dass die Beschichtung über eine Dicke der Beschichtung variierende Empfindlichkeiten für Photonen gleicher Wellenlänge aufweist.

Bevorzugt ist weiterhin vorgesehen, dass es sich bei der Beschichtung um eine einzelne Schicht handelt. Die unterschiedlichen Bereiche sind unterschiedliche Schichtlagen, die unterschiedlich starke Photosensitivitäten für unterschiedliche oder gleiche Wellenlängen unterschiedlicher Stärke besitzen. Denkbar ist auch, dass die unterschiedlichen Schichtlagen nicht wellenlängensensitiv, sondern sensitiv auf die Bestrahlungsstärke, d.h. die Intensität reagieren.

Noch bevorzugter ist allerdings vorgesehen, dass der erste Bereich als eine erste Schicht ausgebildet wird und der zweite Bereich als eine zweite Schicht auf der ersten Schicht ausgebildet wird. Es können natürlich beliebig viele weitere Schichten aufgetragen werden, die beliebig viele weitere Bereiche bilden, die bevorzugt in einem gemeinsamen Belichtungs- und einem Entwicklungsschritt gemeinsam bearbeitet werden.

Bevorzugt ist weiterhin vorgesehen, dass die Beschichtung gegenüber der Strahlungseinrichtung bewegt wird/beweglich ist. Insbesondere ist eine bewegliche Halterung zur Bewegung der Beschichtung gegenüber der Strahlungseinrichtung vorgesehen. Die Beschichtung kann sich auf einem Substrat befinden, wobei sich das Substrat wiederum auf einem Substrathalter befindet. Bevorzugt ist der Substrathalter beweglich zur Bewegung des Substrats mit Beschichtung gegenüber der Strahlungseinrichtung ausgebildet.

Die Erfindung beschreibt insbesondere ein Verfahren und eine Vorrichtung zur, insbesondere maskenlosen, 2.5D bzw. 3D Belichtung der Beschichtung bzw. eines Schichtsystems, aufweisend mindestens zwei überlagernde oder auf unterschiedlichen Tiefen liegende photosensitive Schichten. Diese 2.5D bzw. 3D Belichtung wird im weiteren Verlauf des Textes auch als Raumbelichtung bezeichnet, um sie von einer 2D, also einer Belichtung in einer Ebene zu unterscheiden. Insbesondere versteht man unter einer Raumbelichtung eine Belichtung, bei der 2.5D bzw. 3D Strukturen direkt in einem einzigen Belichtungsprozess erzeugt werden können. Unter einem Belichtungsprozess versteht man die Menge aller Verfahrensschritte zwischen dem Beladen des Substrats und der Entnahme des Substrats aus der Vorrichtung.

Die erfindungsgemäße Vorrichtung und das erfindungsgemäße Verfahren weisen mehrere Vorteile in Gegensatz zum Stand der Technik auf.

Ein Vorteil gegenüber dem Stand der Technik besteht in der Möglichkeit, die Raumbelichtung bei sehr hoher Geschwindigkeit und gleichzeitig hoher Präzision aufgrund des Wegfalls mehrfacher Justierungs- und Zwischenbearbeitungsschritte durchzuführen. Insbesondere kann auf eine mehrfache Belichtung mit Einzelmasken, die vor jedem Belichtungsschritt ausgerichtet werden müssten, sowie auf eine Mehrfachbeschichtung und Mehrfachentwicklung verzichtet werden. Durch diesen erfindungsgemäßen Vorteil ergibt sich insbesondere eine Erhöhung des Durchsatzes.

Ein weiterer Vorteil besteht darin, dass sich die Genauigkeit der Layouts in den einzelnen Schichten immens erhöht, da der Ausrichtungsfehler wegfällt, der bei der Ausführung mehrerer Einzelbelichtungen auf Grund der Maskenausrichtung entsteht.

Ein weiterer Vorteil besteht darin, dass die Strukturierungstiefe über Schärfentiefe und chemisches Verhalten der Lacke hinaus erhöht wird. Unter Strukturierungstiefe versteht man den Bereich der Beschichtung, indem die chemische Reaktion durch Photonenbeschuss erfolgt.

Im Stand der Technik müssen die optischen Elemente zur Belichtung so konzipiert sein, dass die Photonen, die für die Belichtung verwendet werden, in eine Fokusebene fokussiert werden, oder dass im Schattenwurfprinzip eine Positionierung des photoempfindlichen Bereichs im Nahfeld der Maske erfolgt.

Erfindungsgemäß vorteilhaft ist eine Fokussierung des Lichts auf den einzelnen photosensitiven Bereich nicht notwendig, bzw. erfolgt im Rahmen der Schärfentiefe der Projektion gleichzeitig, oder kann durch einen im Gerät fix vorgesehenen Abstand der wellenlängenabhängigen Fokusebenen erfolgen. Die Photonen jeder Wellenlänge können vorteilhaft die photosensitive Beschichtung durchleuchten, erzeugen aber nur in jenem Bereich eine photochemische Reaktion, in dem das Material auf die Photonen der entsprechenden Wellenlänge reagiert.

Ein weiterer Vorteil besteht darin, überhängende Strukturen aufgrund des in einem einzigen Arbeitsschritt entfernbaren Stützmaterials zu erzeugen. Unter Stützmaterial wird jenes Material verstanden, dass sich zwischen einer überhängenden Struktur, insbesondere einem auszubildenden Deckel, und dem Substrat befindet.

Ein weiterer Vorteil besteht darin, dass eine hochgenaue vertikale, also in Richtung der Dicke der Beschichtung, Strukturierungsmöglichkeit gegeben wird. Während Verfahren und Vorrichtungen im Stand der Technik die Fokussierung der Photonen in eine Fokusebene einstellen und kontrollieren müssen, kann in der Erfindung eine direkte Durchstrahlung der Beschichtung ortsaufgelöst, punktweise, insbesondere mittels Strahlenbündeln, erfolgen. Weder muss besonders auf die Schärfentiefe noch auf die Fokusebene achtgegeben werden.

Des Weiteren ist mit Hilfe der Erfindung vorteilhaft die Höhe der Raumstrukturen präziser kontrollierbar als z.B. mit der Graustufenlithografie, bei der die Belichtung tiefenabhängig über die Bestrahlungsdosis kontrolliert wird. Das erlaubt die Herstellung von höheren, formtreueren freistehenden Dachstrukturen, insbesondere von Membranen mit großen darunterliegenden Hohlräumen.

Ein weiterer Vorteil besteht in der erhöhten lateralen Auflösung, da vorhergehende Verfahrensschritte nicht mehr durchgeführt werden. Da es nur mehr einen durchgehenden Belichtungsprozess gibt, kann die Belichtung nicht mehr durch Streu- und/oder Reflexionszentren vorhergehender, erstellter Strukturen negativ beeinflusst werden.

Ein weiterer Vorteil besteht in der Möglichkeit, die Wellenlänge und/oder Dosis sehr einfach durch individuell steuerbare Photonenquelle und/oder Einstellung eines Filters vor einer breitbandigen Photonenquelle gezielt einzustellen. Das erfindungsgemäße Verfahren lässt sich daher sehr einfach durch die erfindungsgemäße Vorrichtung umsetzen.

Ein weiterer Vorteil besteht darin, dass unterschiedliche Strukturen jedes Bereichs jeweils durch die Photonen einer Wellenlänge geschrieben werden, aber auch selektiv durch die Vielfachbelichtung anders strukturiert werden können.

Ein weiterer Vorteil für die erfindungsgemäße Vorrichtung mit DMD besteht vor allem darin, dass die Heiz- und Entwicklungsschritte für jede einzelne Schicht ersetzt werden durch einen einzigen Heiz- und Entwicklungsschritt am Ende der Belichtung. In einer Beschichtung mit n Bereichen mit n>1 erspart man sich daher n-1 Heiz- und Entwicklungsschritte, was zu einer immensen Durchsatzsteigerung des Prozesses führt.

### Photosensitive Beschichtung

Die erfindungsgemäßen Ausführungsformen beruhen insbesondere darauf, dass mit Hilfe einer polychromatischen Photonenquelle übereinanderliegende zu belichtende Layouts gleichzeitig und vor allem nicht kumulativ belichtet werden.

Insbesondere können die übereinanderliegenden n Layouts so belichtet werden, dass das i-te Layout im i-ten Bereich der Beschichtung durch die Spiegel der i+j*n-ten Reihe des DMDs belichtet werden, wobei gilt, dass 0<=j<=m, mit m=N/n und N Anzahl der DMD Spiegelreihen ist.

Insbesondere ist es auch möglich, übereinanderliegende Layouts zu belichteten, indem zwischen den Layouts zeitlich umgeschaltet wird. Pro Zeiteinheit projiziert das DMD daher mindestens zwei Layouts, genauer gesagt Teilabschnitte des Layouts, auf die Beschichtung.

Um eine solche Belichtung durchführen zu können ist insbesondere eine photosensitive Beschichtung vorgesehen, bei der Photonen mit unterschiedlichen Wellenlängen unterschiedliche Tiefenbereiche belichten, ohne auf die angrenzenden Tiefenbereiche zu wirken.

In einer **ersten** erfindungsgemäßen Ausführungsform besteht die Beschichtung aus einer einzelnen Schicht. Diese Schicht verfügt über sich, insbesondere über die Tiefe, ändernde physikalische und/oder chemische Eigenschaften, insbesondere eine unterschiedliche Empfindlichkeit für Photonen einer gewissen Wellenlänge. In einer ersten Ausführungsform kann der Übergang zwischen den unterschiedlichen physikalischen und/oder chemischen Eigenschaften als Funktion der Tiefe durch eine Stufenfunktion mathematisch beschrieben werden.

Alternativ ändern sich die chemischen und/oder physikalischen Eigenschaften als Funktion der Tiefe kontinuierlich. In diesem Fall sind die chemischen und/oder physikalischen Eigenschaften durch eine stetig differenzierbare Funktion beschreibbar. Um eine Vereinfachung durchzuführen werden alle derartigen Änderungen der chemischen und/oder physikalischen Eigenschaften als Funktion der Tiefe als Gradienten bezeichnet.

Insbesondere kann es auch sein, dass die chemischen und physikalischen Eigenschaften der Beschichtung homogen sind und die sich örtlich ändernde Photosensitivität durch die Absorption bedingt wird, welche wellenlängenabhängig und dickenabhängig ist. Die Intensität eines Photonenstroms aus Photonen einer gewissen Wellenlänge nimmt als Funktion der Eindringtiefe kontinuierlich ab. Durch die Abnahme der Intensität verändert sich damit auch die Photosensitivität. Die Tiefenselektivität wird also durch einen Sättigungsmechanismus erreicht - dem Ausbleichen. Die Strahlung führt einerseits zur Belichtung, andererseits wird der belichtete Bereich dadurch transparent. Es entsteht somit eine Front durch die sich die Strahlung "frisst", wodurch ein 2,5-dimensionales Gelände erzeugt werden kann.

In einer **zweiten** erfindungsgemäßen Ausführungsform besteht die Beschichtung aus mehreren, mindestens also zwei, Schichten. Diese Ausführungsform ist besonders vorteilhaft, da es durch Beschichtungsverfahren, insbesondere durch Schleuderbelackungsverfahren, besonders einfach ist, mehrere Schichten, von denen eine jede einzelne eine wohldefinierte physikalische und/oder chemische Eigenschaft in Bezug auf Photonen einer spezifischen Wellenlänge besitzt, herzustellen. Insbesondere kann bereits bei der Materialauswahl auf unterschiedliche Materialien verschiedener Hersteller zurückgegriffen werden, die genau jene chemischen und/oder physikalischen Eigenschaften besitzen, die notwendig sind, um das erfindungsgemäße Verfahren durchführen zu können.

In einer **dritten** erfindungsgemäßen Ausführungsform kann die Beschichtung eine Kombination aus den ersten beiden Ausführungsformen sein. Denkbar wäre also, dass die Beschichtung aus mehreren Schichten besteht und das mindestens eine der Schichten selbst über einen Gradienten gemäß der ersten Ausführungsform verfügt.

In einer besonderen erfindungsgemäßen Ausführungsform reagieren Lösungsmittel und/oder Photoinitiatoren unterschiedlicher Schichten nicht über Schichtgrenzen hinweg. Eine solche nachteilige Reaktion kann auf ein Minimum reduziert werden, indem die erfindungsgemäße Belichtung schnellstmöglich nach der Aufbringung der Beschichtung erfolgt.

In einer besonderen erfindungsgemäßen Form wird zwischen den photoempfindlichen Lagen eine Stopp-Schicht eingebracht, die das Ausbreiten der sognannten "chemisch verstärkten" Photoreaktion zwischen den Schichten unterbricht. Dies kann auch zur Erreichung einer stufenförmigen, bestrahlungsdosisabhängigen Belichtung mit einer einzelnen Wellenlänge genutzt werden.

In einer speziellen erfindungsgemäßen Ausführungsform ist eine Querempfindlichkeit der Photosensitivität in den Schichten unterschiedlich stark ausgebildet. Unter Querempfindlichkeit versteht man die Photosensitivität der Beschichtung normal zur Bestrahlungsrichtung. Je höher die Querempfindlichkeit, desto weniger scharf kann ein Punkt der Beschichtung belichtet und/oder entwickelt werden. Denkbar ist beispielsweise, dass ein paralleler einfallender Strahl von Photonen eine erste Schicht stärker in der lateralen, d.h. horizontalen, Richtung belichtet, als eine zweite Schicht.

Die photosensitive Beschichtung kann aus jeder Art von photosensitivem Material hergestellt werden, vorzugsweise werden aber Lacke, insbesondere Photolacke verwendet.

In einer ganz besonders bevorzugten Ausführungsform wird mindestens eines der folgenden Materialien verwendet.
- TOK PMER P-LA900PM
- TOK CR4000
- AZ nLOF2000 Serie
- Allresist Atlas 46
- Allresist Atlas 46R
- JSRIX335H
- JSRWPR5100
- JSR THB

### Vorrichtung

Bei der erfindungsgemäßen Vorrichtung handelt es sich vorzugsweise um einen maskenlosen Belichter mit mindestens einer Mikrospiegeleinheit (DMD), die um eine polychromatische Photonenquelle erweitert wurde.

In einer ganz speziellen erfindungsgemäßen Ausführungsform kann die erfindungsgemäße Vorrichtung über mehrere DMDs verfügen, die dadurch mehrere Positionen einer Beschichtung gleichzeitig belichten können. Insbesondere kann für jede Wellenlänge ein einzelnes DMD verwendet werden, oder das DMD in, mit unterschiedlichen Wellenlängen bestrahlte, Bereiche zerteilt werden. Der Offenbarungsinhalt ist dann sinngemäß auf jedes DMD einzeln anzuwenden.

Eine alternative erfindungsgemäße Vorrichtung ist ein maskenbasierter Belichter, der mit der entsprechenden polychromatischen Photonenquelle erweitert wurde. Dadurch wird die Anwendung des erfindungsgemäßen Verfahrens auch für maskenbasierte Belichter möglich.

Alle erfindungsgemäßen Vorrichtungen verfügen insbesondere mindestens über eine polychromatische Photonenquelle. Die Photonenquelle ist ein Teil eines, im Allgemeinen aus sehr vielen optischen Elementen bestehenden, optischen Systems. Das optische System wird im weiteren Text genauer beschrieben.

### Photonenquelle

Unter Photonenquelle wird im weiteren Verlauf des Textes ein Bauteil oder eine Bauteilgruppe verstanden, das bzw. die in der Lage ist/sind, Photonen mit mindestens einer spezifischen Wellenlänge zu emittieren. In speziellen Ausführungsformen kann eine einzelne Photonenquelle polychromatisch sein.

In einer **ersten** erfindungsgemäßen Ausführungsform handelt es sich bei der Photonenquelle um eine Vorrichtung, die Photonen mit einem polychromatischen Spektrum emittiert, insbesondere um eine Quecksilberlampe. Quecksilber weist ein polychromatisches Spektrum im UV Bereich auf. Es könnten beispielsweise in der Photonenquelle Filter vorgesehen werden, die nur die Photonen einer benötigten Wellenlänge passieren lassen. Durch das Schalten der Filter kann zwischen den unterschiedlichen Wellenlängen gewechselt werden.

In einer **zweiten** erfindungsgemäßen Ausführungsform handelt es sich bei der Photonenquelle um eine Menge von einzelnen, monochromatischen Photonenquellen.

In einer speziellen Ausführungsform der zweiten erfindungsgemäßen Ausführungsform handelt es sich bei jeder der einzelnen, monochromatischen Photonenquellen um eine Licht emittierende Diode (eng.: LED) bzw. um ein Licht emittierendes Diodenfeld (eng.: LED-array). Da jede LED bzw. jedes LED-array immer nur eine monochromatische Strahlung emittieren kann, müssen mehrere entsprechende Bauteile mit unterschiedlichen Wellenlängen verwendet werden. Durch die Möglichkeit, die unterschiedlichen LEDs bzw. LED-arrays, insbesondere elektronisch, schalten zu können, kann vorteilhafterweise auf die Verwendung von, insbesondere mechanischen, Filtern verzichtet werden.

Der Vollständigkeit halber wird aber die Möglichkeit einzelne, monochromatische Photonenquellen auch einzeln, elektronisch schalten zu können, als auch durch andere Mechanismen wellenlängenveränderliche Quellen ebenfalls als "Filtern" bezeichnet. Wird im Text daher von der Filterung einer solchen einzelnen, monochromatischen Photonenquelle gesprochen ist damit gemeint, dass diese eine, und nur diese eine, monochromatische Photonenquelle Photonen emittiert, während alle anderen monochromatischen Photonenquellen keine Photonen emittieren.

In einem beispielhaften Aufbau sind die genannten monochromatischen Photonenquellen als polychromatische Photonenquellenmit unterschiedlicher spektraler Verteilung realisiert und nur vereinfachend als monochromatisch, bzw. als unterschiedliche Wellenlänge bezeichnet.

### Optisches System

Das optische System der erfindungsgemäßen Vorrichtung ist eine Menge optischer und/oder mechanischer und/oder elektrischer Elemente. Das optische System weist mindestens eine Photonenquelle auf.

### Weitere Elemente können sein

- DMD
- Spiegel
- Linsen
- Prismen
- Aperturen
- Masken

Vorzugsweise befindet sich auch mindestens ein optisches Element im sekundären Pfad, d.h. im optischen Pfad, zwischen dem DMD und der Beschichtung.

Noch bevorzugter handelt es sich bei den optischen Elementen um abbildende optische Elemente.

In einer ganz bevorzugten erfindungsgemäßen Ausführungsform handelt es sich bei den optischen Elementen um solche, die in der Lage sind, die aktive Struktur des DMDs durch eine mathematische, insbesondere affine, Transformation auf ein Bild in der Beschichtung abzubilden. Bevorzugt werden insbesondere Scherungs- und Skaliertransformationen. Ein solches optisches System wurde bereits in der Druckschrift WO2018113918A1 erwähnt.

### Relativbewegung

Die erfindungsgemäße Vorrichtung ist vorzugsweise so konstruiert, dass sich ein Substrathalter, auf dem ein Substrat angeordnet ist, welches mit der photosensitiven Beschichtung beschichtet wird, aktiv bewegen kann, während das optische System statisch ist. Es ist alternativ möglich, die Vorrichtung so zu konstruieren, dass sich das optische System bewegt während der Substrathalter statisch ist oder dass sich optisches System und/oder Substrathalter bewegen können, bzw. eine Ablenkeinrichtung für die laterale Bewegung erfolgt. Bei kleinen Belichtungsbereichen, bzw. großen Belichtungselementen kann die laterale Bewegung auch entfallen.

Bevorzugt ist somit, dass eine Relativbewegung zwischen dem Substrathalter und dem optischen System ermöglicht wird.

Durch die Fixierung des Substrats auf dem Substrathalter wird eine präzise Relativbewegung zwischen dem Substrat und dem optischen System ermöglicht.

### Verfahren

Das erfindungsgemäße Verfahren erlaubt insbesondere die Formung von Kavitäten mittels der Strukturierung von Seitenwänden und Decken im MEMS- und Mikrofluidik-Bereich in einem einzigen Belichtungsschritt.

Das erfindungsgemäße Verfahren erlaubt insbesondere die gleichzeitige Belichtung von Umverdrahtungsebenen (engl.: redistribution layer) und Durchkontaktierung, wie sie im Advanced Packaging eingesetzt werden.

Das erfindungsgemäße Verfahren kann vorteilhafterweise eingesetzt werden für
- Maskenlose Belichter, insbesondere, Maskenlose Laserbelichter,
- Andere maskenlose Systeme, speziell inklusive Laserscanner,
- Maskenbasierte Belichter, insbesondere Mask Aligner, insbesondere Stepper und Scanner mit wechselbarer oder versetzbarer Maske.

In einer besonderen Ausführungsform kann das erfindungsgemäße Verfahren auch für maskenbasierte Belichter verwendet werden.

Das erfindungsgemäße Verfahren wird vorzugsweise für maskenlose Belichter, insbesondere für maskenlose Laserbelichter, verwendet. Das bevorzugte erfindungsgemäße Verfahren gemäß einer ersten Ausführungsform wird im Folgenden genauer beschrieben.

In einem **ersten** Verfahrensschritt des ersten erfindungsgemäßen Verfahrens wird ein Substrat mit mindestens einer ersten photosensitiven Schicht beschichtet. Das Substrat wird dazu vorzugsweise in eine eigens für Beschichtungen vorgesehene Beschichtungsvorrichtung geladen und dort beschichtet.

Die Beschichtung erfolgt vorzugsweise mit Hilfe einer Schleuderbelackung. Sollte es sich bei der photosensitiven Beschichtung um eine Beschichtung der ersten Ausführungsform handeln, d.h. um eine Beschichtung, die über eine einzige Schicht verfügt, kann der folgende zweite Verfahrensschritt der Beschichtung weiterer Schichten übersprungen werden.

Voraussetzung dafür ist, dass die einzelne Beschichtung über mindestens zwei Bereiche verfügt, sodass die unterschiedlichen zu belichtenden Layouts genau genug aufgelöst werden können.

In einem **zweiten** Verfahrensschritt des ersten erfindungsgemäßen Verfahrens wird das Substrat mit mindestens einer zweiten photosensitiven Schicht beschichtet. Vorzugsweise erfolgt die Beschichtung der zweiten photosensitiven Schicht in derselben Beschichtungsvorrichtung. Die Beschichtungsvorrichtung ist daher vorzugsweise mit mindestens zwei vollständigen Beschichtungsmitteln, insbesondere Schläuchen oder Düsen, versehen, um eine Vermischung der unterschiedlich sensitiven Lacke zu verhindern. Erfindungsgemäß ist das Verfahren nicht auf diese zweite photosensitive Schicht eingeschränkt. Verfügt die erfindungsgemäße Vorrichtung über eine Photonenquelle, die Photonen mit n optisch voneinander trennbare Wellenlängen emittieren kann, kann es erfindungsgemäß auch sinnvoll sein, n unabhängig voneinander belichtbare photosensitive Schichten übereinander zu erzeugen. Das erfindungsgemäße Verfahren wird nachfolgend zumeist anhand zweier Schichten beschrieben. Die Erweiterung auf n Schichten gilt analog.

In einer speziellen erfindungsgemäßen Ausführungsform ist der zweite Verfahrensschritt nicht notwendig, sofern sich die Wellenlängensensitivität der ersten abgeschieden Schicht als Funktion des Ortes in Dickenrichtung ändert.

In einem **dritten** Verfahrensschritt des ersten erfindungsgemäßen Verfahrens wird das beschichtete Substrat in eine erfindungsgemäße Vorrichtung geladen und es erfolgt eine Relativbewegung zwischen dem Substrat und dem optischen System zu einer ersten Position.

In einem **vierten** Verfahrensschritt des ersten erfindungsgemäßen Verfahrens werden in der ersten Position die Spiegel des DMD in eine erste Konfiguration geschaltet. Es kann, insbesondere zur Prozessbeschleunigung, die Schaltung der Spiegel des DMD in die erste Konfiguration schon während der Relativbewegung gemäß dem dritten Verfahrensschritt stattgefunden haben.

In einem **fünften** Verfahrensschritt des ersten erfindungsgemäßen Verfahrens werden in der ersten Position die Spiegel des DMD, die sich in der ersten Konfiguration befinden, durch die Photonenquelle mit den Photonen einer ersten Wellenlänge bestrahlt. Das von dem DMD zu erzeugende erste Layout wird nun in den ersten photosensitiven Bereich projiziert. Eine Einstellung eines Fokuspunktes ist vorteilhaft nicht notwendig.

Die Photonen mit der ersten Wellenlänge durchstrahlen vorteilhaft alle vorhandenen Bereiche. Da erfindungsgemäß aber nur einige, insbesondere nur einer, der Bereiche der Beschichtung, photosensitiv für die Photonen der ersten Wellenlänge sind, werden auch nur einige, insbesondere nur einer, der Bereiche der Beschichtung photochemisch verändert.

In einem **sechsten** Verfahrensschritt des ersten erfindungsgemäßen Verfahrens werden in der ersten Position die Spiegel des DMD in eine zweite Konfiguration geschaltet.

In einem **siebten** Verfahrensschritt des ersten erfindungsgemäßen Verfahrens werden in der ersten Position die Spiegel des DMD, die sich in der zweiten Konfiguration befinden, durch die Photonenquelle mit den Photonen einer zweiten Wellenlänge bestrahlt. Das von dem DMD zu erzeugende zweite Layout wird nun in einen zweiten Bereich projiziert.

Vorteilhaft ist eine Einstellung des Fokuspunktes in den zweiten Bereich nicht notwendig. Die Photonen mit der zweiten Wellenlänge durchstrahlen alle vorhandenen Bereiche Da aber nur einige Bereiche, insbesondere nur ein Bereich, photosensitiv für die Photonen der zweiten Wellenlänge sind/ist, werden auch nur einige Bereiche, insbesondere nur ein Bereich, photochemisch verändert.

Existieren mehr als zwei photosensitive Bereiche müssen die Verfahrensschritte sechs bis sieben mit anderen Konfigurationen für die Spiegel des DMDs und mit anderen Wellenlängen entsprechend wiederholt werden.

In einem **achte** Verfahrensschritt des ersten erfindungsgemäßen Verfahrens erfolgt eine Relativbewegung zwischen dem Substrat und dem optischen System zu einer zweiten Position.

Die Verfahrensschritte vier bis acht werden nun solange wiederholt, bis die gesamte zu bearbeitende Fläche belichtet wurde.

In einem **neunten** Verfahrensschritt des ersten erfindungsgemäßen Verfahrens erfolgen das Entladen des Substrats sowie die Entwicklung der Beschichtung auf dem Substrat. Vorteilhaft muss nur einmal entwickelt werden.

Die genannten Verfahrensschritte müssen nicht notwendigerweise alle in dieser Reihenfolge erfolgen. Vorzugsweise werden einige der genannten Verfahrensschritte gleichzeitig durchgeführt. Insbesondere erfolgen die Relativbewegung, die Belichtung und die Schaltung des DMD gleichzeitig bzw. zumindest so schnell, dass es nicht mehr notwendig bzw. möglich ist, die Verfahrensschritte voneinander getrennt zu betrachten.

Insbesondere diese Gleichzeitigkeit führt zu einem entsprechend hohen Durchsatz und zur hohen Wirtschaftlichkeit. Der Übergang zwischen einigen der Verfahrensschritte ist zumindest fließend.

Neben der Möglichkeit der Verwendung des erfindungsgemäßen Verfahrens für einen maskenlosen Belichter mit einem DMD kann das Verfahren gemäß einer **zweiten Ausführungsform** auch für Maskenbelichter verwendet werden.

Die **ersten drei** Verfahrensschritte des zweiten erfindungsgemäßen Verfahrens sind identisch zu den ersten drei Verfahrensschritten des ersten erfindungsgemäßen Verfahrens.

In einem **vierten** Verfahrensschritt des zweiten erfindungsgemäßen Verfahrens wird das Substrat relativ zu einer ersten Maske in einem Maskenbelichter ausgerichtet. Vorzugsweise wird das Substrat in eine Endposition gebracht und fixiert. Danach bewegt sich die erste Maske relativ zum Substrat. Die Ausrichtung erfolgt dabei vorzugsweise anhand von Ausrichtungsmarken zwischen der ersten Maske und dem Substrat.

In einem **fünften** Verfahrensschritt des zweiten erfindungsgemäßen Verfahrens erfolgt die vollflächige Belichtung der Beschichtung durch die erste Maske mit den Photonen der ersten Wellenlänge.

In einem **sechsten** Verfahrensschritt des zweiten erfindungsgemäßen Verfahrens wird die erste Maske mit einer zweiten Maske ausgetauscht.

In einem **siebten** Verfahrensschritt des zweiten erfindungsgemäßen Verfahrens wird das Substrat relativ zu der zweiten Maske im Maskenbelichter ausgerichtet. Vorzugsweise verbleibt das Substrat in seiner fixierten Endposition. Danach bewegt sich vorzugsweise die zweite Maske relativ zum Substrat. Die Ausrichtung erfolgt dabei vorzugsweise anhand von Ausrichtungsmarken zwischen der zweiten Maske und dem Substrat.

In einem **achten** Verfahrensschritt des zweiten erfindungsgemäßen Verfahrens erfolgt die vollflächige Belichtung der Beschichtung durch die zweite Maske mit den Photonen der zweiten Wellenlänge.

Die Verfahrensschritte sechs bis acht können nun für andere Masken und Wellenlängen wiederholt werden, sofern die Beschichtung für weitere Belichtungen ausgelegt ist.

In einem **neunten** Verfahrensschritt des zweiten erfindungsgemäßen Verfahrens erfolgt das Entladen des Substrats.

In einem **zehnten** Verfahrensschritt des zweiten erfindungsgemäßen Verfahrens erfolgt die Entwicklung der Beschichtung auf dem Substrat. Vorteilhaft muss nur einmal entwickelt werden.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
Figur 1a einen ersten Verfahrensschritt eines ersten erfindungsgemäßen Verfahrens,
Figur 1b einen zweiten Verfahrensschritt des ersten erfindungsgemäßen Verfahrens,
Figur 1c einen dritten Verfahrensschritt des ersten erfindungsgemäßen Verfahrens,
Figur 1d einen vierten und fünften Verfahrensschritt des ersten erfindungsgemäßen Verfahrens,
Figur 1e einen sechsten und siebten Verfahrensschritt des ersten erfindungsgemäßen Verfahrens,
Figur 1f einen achten Verfahrensschritt des ersten erfindungsgemäßen Verfahrens,
Figur 2a einen dritten und vierten Verfahrensschritt eines zweiten erfindungsgemäßen Verfahrens,
Figur 2b einen fünften Verfahrensschritt des zweiten erfindungsgemäßen Verfahrens und
Figur 2c einen sechsten, siebten und achten Verfahrensschritt des zweiten erfindungsgemäßen Verfahrens.

In den Figuren sind gleiche Bauteile oder Bauteile mit der gleichen Funktion mit den gleichen Bezugszeichen gekennzeichnet.

Die Figuren sind nicht maßstabsgetreu. Insbesondere werden die photosensitiven Schichten 3a, 3b und das optische System 4 mit all seinen Elementen im Vergleich zum Substrat 1 nicht maßstabsgetreu dargestellt.

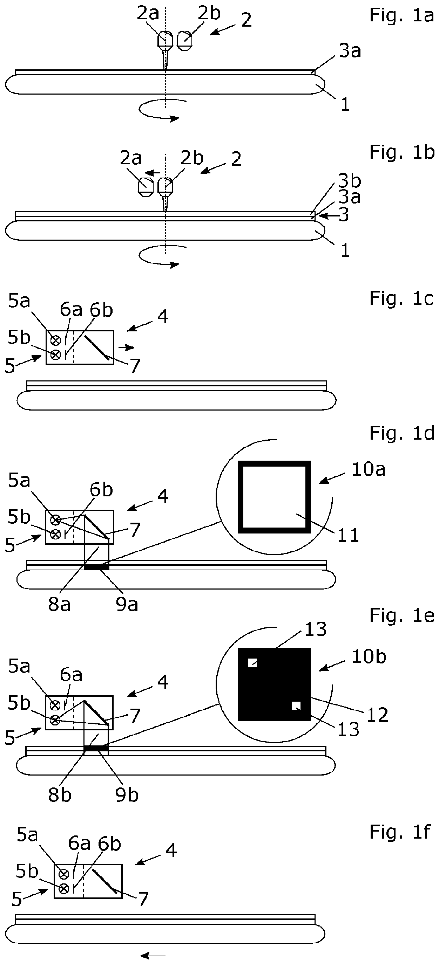

Das erfindungsgemäße Prinzip wird beispielhaft am einfachsten und effizientesten dadurch veranschaulicht, indem man jeden Bereich als einzelne, aufgetragene Schicht darstellt. Daher wird in den folgenden Figuren 1a-1f das erfindungsgemäße Verfahren anhand einer Beschichtung 3 beschrieben, die aus zwei photosensitiven Schichten 3a und 3b besteht, welche die Bereiche darstellen, die unterschiedlich stark auf die Photonen unterschiedlicher Wellenlängen reagieren. Der Fachmann erkennt, dass man die beiden Schichten 3a und 3b auch allgemeiner als Bereiche betrachten kann, die beispielsweise Teil einer einzelnen Schicht sind, die dann äquivalent zur Beschichtung wäre. In diesem Fall müsste man sich das Aufbringen zweier Schichten in den Figuren 1a-1b durch das Aufbringen einer einzelnen Schicht ersetzt denken.

Die **Figur 1a** zeigt einen ersten Verfahrensschritt eines ersten erfindungsgemäßen Verfahrens, bei dem ein Substrat 1, über ein erstes, einzelnes Beschichtungselement 2a eines Beschichtungssystems 2, vorzugsweise einen Schlauch oder deine Düse, mit einer ersten photosensitiven Schicht 3a beschichtet wird. Die photosensitive Schicht 3a entspricht hier also einem ersten Bereich der Beschichtung. Die Beschichtung erfolgt vorzugsweise durch einen Schleuderbelacker. Die photosensitive Schicht 3a wird dann, wie in der Figur 1 dargestellt, durch eine Rotation des Substrats 1 um eine Achse seines Zentrums, über die Substratoberfläche des Substrats 1 verteilt. Es kann jede andere Art von Beschichtungsvorgang verwendet werden, um die photosensitive Schicht 3a auf das Substrat 1 aufzubringen. Die photosensitive Schicht 3a ist für eine erste Photonenart mit einer ersten Wellenlänge sensitiv.

Die **Figur 1b** zeigt einen zweiten Verfahrensschritt des ersten erfindungsgemäßen Verfahrens, bei dem ein Substrat 1, über ein zweites, einzelnes Beschichtungselement 2a eines Beschichtungssystems 2, vorzugsweise einen Schlauch oder eine Düse, mit einer zweiten photosensitiven Schicht 3b beschichtet wird. Die photosensitive Schicht 3b entspricht hier also einem zweiten Bereich der Beschichtung. Die Beschichtung erfolgt vorzugsweise durch einen Schleuderbelacker. Die photosensitive Schicht 3b wird dann, wie in der Figur 1b dargestellt, durch eine Rotation des Substrats 1 um eine Achse seines Zentrums, über die Oberfläche der ersten photosensitiven Schicht 3a verteilt. Es kann jede andere Art von Beschichtungsvorgang verwendet werden, um die photosensitive Schicht 3a auf die Oberfläche der photosensitiven Schicht 3a aufzubringen. Die photosensitive Schicht 3b ist für eine zweite Photonenart mit einer zweiten Wellenlänge sensitiv. Die beiden photosensitiven Schichten 3a und 3b bilden eine Beschichtung 3. Es ist denkbar, der Beschichtung 3 weitere photosensitive Schichten hinzuzufügen. Um die Figuren allerdings möglichst einfach zu halten, wird das erfindungsgemäße Verfahren nur anhand eines Schichtsystems 3 mit zwei photosensitiven Schichten 3a, 3b beschrieben.

Da die photosensitiven Schichten 3a, 3b andere physikalische und/oder chemische Eigenschaften, insbesondere in Bezug auf ihre Sensitivität gegenüber der Wellenlänge einfallender Photonen, besitzen, ist es besonders vorteilhaft, die Materialien aus denen die photosensitiven Schichten 3a, 3b bestehen, über zwei voneinander getrennte, einzelne Beschichtungselemente 2a, 2b abzuscheiden. Denkbar ist auch, dass das Beschichtungssystem 2 nur über ein einzelnes Beschichtungselement verfügt.

Die **Figur 1c** zeigt einen dritten Verfahrensschritt des ersten erfindungsgemäßen Verfahrens, bei dem das Substrat 1 unter einem optischen System 4 an einer ersten Position positioniert wird. Die Relativbewegung zwischen dem Substrat 1 und dem optischen System 4 wird in den weiteren Figuren so dargestellt, dass sich das Substrat 1 relativ zum als statisch angesehenen optischen System 4 bewegt. Das optische System 4 verfügt insbesondere über eine Photonenquelle 5, bestehend aus mindestens zwei einzelnen Photonenquellen 5a, 5b. Die einzelnen Photonenquellen 5a, 5b sind die graphische Repräsentation für die Ursprünge von Photonen mit unterschiedlichen Wellenlängen. Bei den einzelnen Photonenquellen 5a, 5b muss es sich dabei nicht notwendigerweise um zwei unterschiedliche Bauteile oder Bauteilgruppen handeln. Denkbar wäre beispielsweise, dass die Photonenquelle 5 eine Quecksilberstrahlungsquelle ist. Da Quecksilber Photonen mit unterschiedlichen Wellenlängen emittieren kann, würde eine Quecksilberstrahlungsquelle auch aus mehreren, insbesondere mindestens zwei, einzelnen Photonenquellen 5a, 5b bestehen. Die erfindungsgemäße Photonenquelle 5 bzw. das optische System 6 verfügen über Filter 6a, 6b, mit deren Hilfe entschieden werden kann, welche Photonen einer welcher einzelnen Photonenquelle 5a, 5b für die Belichtung herangezogen werden. Die Filter sind nicht notwendigerweise als eigenständige Bauteile oder Bauteilgruppen zu interpretieren. Bei der Verwendung von einzelnen Photonenquellen 5a, 5b, die aus LEDs oder LED-Feldern aufgebaut sind, sind keine mechanischen, elektrischen oder optischen Filter notwendig, da durch das Ein- bzw. Ausschalten der LEDs der Photonenstrom einer entsprechenden einzelnen Photonenquelle 5a, 5b direkt gesteuert werden kann. In diesem Zusammenhang versteht man unter der Filterung der Photonen einer einzelnen Photonenquelle 5a, 5b das Ausschalten der Photonenquellen 5a, 5b. Die Filter 6a, 6b werden vorzugsweise als eigene Bauteile bzw. Bauteilgruppen ausgeführt und elektronisch und/oder optisch und/oder mechanisch geschalten, wenn die zugrundeliegende Photonenquelle 5 über mindestens eine einzelne Photonenquelle 5a, 5b verfügt, die nicht oder nicht schnell genug geschalten werden kann, oder die von sich aus polychromatisch ist. So muss eine Photonenquelle 5, die aus einer Quecksilberstrahlungsquelle besteht über Filter 6a, 6b verfügen, um zwei Emissionslinien des polychromatischen Quecksilberspektrums exakt voneinander trennen zu können.

In den beiden nächsten Figuren wird das Prinzip der Belichtung anhand von Layouts 10a, 10b anschaulicher beschrieben. Es können entweder Positiv- und/oder Negativlacke für die einzelnen photosensitiven Schichten 5a, 5b verwendet werden. Die Beispiele werden anhand von Negativlacken beschrieben, d.h. die Materialien der photosensitiven Schichten 3a, 3b, die von Photonen getroffen werden, vernetzen an diesen Stellen und bleiben nach entsprechenden Ausheiz- und/oder Entwicklungsschritten stehen. Die Stellen werden als schwarze Bereiche dargestellt.

Die **Figur 1d** zeigt einen vierten und fünften Verfahrensschritt des ersten erfindungsgemäßen Verfahrens, bei dem die Spiegel des DMD 7 in eine erste Konfiguration geschaltet werden. Des Weiteren wird der Filter 6a geöffnet und der Filter 6b geschlossen. Es können nur die Photonen einer ersten Wellenlänge der ersten, einzelnen Photonenquelle 5a auf das DMD 7 projiziert werden. Das DMD 7 führt dann durch seine einzelnen Spiegel eine ortsaufgelöste Filterung des Photonenstroms durch und projiziert den gewünschten Layoutabschnitt 10a als Sekundärstrahl 8a in die Beschichtung 3. Somit kommt es durch die Wellenlänge der ersten Photonenart ausschließlich in der ersten photosensitiven Schicht 3a, also nur innerhalb des Tiefenbereichs 9a, zu einer chemischen bzw. physikalischen Reaktion der Photonen mit den Molekülen. Im Gegensatz zum Stand der Technik muss mit dem erfindungsgemäßen Verfahren keine Fokussierung des Photonenstroms auf den ersten Tiefenbereich 9a der ersten photosensitiven Schicht 3a durchgeführt werden. Die Photonen der ersten Wellenlänge durchdringen die zweite photosensitive Schicht 3b, ohne dort eine chemische und/oder physikalische Reaktion zu erzeugen, die zu einer Belichtung des zweiten Tiefenbereichs 9b führt.

Die vergrößerte Darstellung zeigt einen vom DMD 7 in die photosensitive Schicht 3a projizierten Layoutabschnitt 10a. Die einzelnen Spiegel des DMDs 7 wurden so geschaltet, dass nur die peripheren, d.h. seitlichen Spiegel des DMDs die Photonen in die photosensitive Schicht 3a belichtet haben. Dadurch wurde ein randförmiger Bereich, der später die Wände einer Kavität 11 bilden soll, belichtet.

Die **Figur 1e** zeigt einen sechsten und siebten Verfahrensschritt des ersten erfindungsgemäßen Verfahrens, bei dem die Spiegel des DMD 7 in eine zweite Konfiguration geschalten werden. Des Weiteren wird der Filter 6b geöffnet und der Filter 6a geschlossen. Es können nur die Photonen einer zweiten Wellenlänge der zweiten, einzelnen Photonenquelle 5b auf das DMD 7 projiziert werden. Das DMD 7 führt dann durch seine einzelnen Spiegel eine ortsaufgelöste Filterung des Photonenstroms durch und projiziert den gewünschten Layoutabschnitt 10b, der sich im Allgemeinen vom Layoutabschnitt aus der Figur 4 unterscheidet, als Sekundärstrahl 8b in die Beschichtung 3. Somit kommt es durch die Wellenlänge der ersten Photonenart ausschließlich in der zweiten photosensitiven Schicht 3b, also nur innerhalb des Tiefenbereichs 9b, zu einer chemischen bzw. physikalischen Reaktion der Photonen mit den Molekülen. Im Gegensatz zum Stand der Technik muss mit dem erfindungsgemäßen Verfahren keine Fokussierung des Photonenstroms auf den zweiten Tiefenbereich 9b der zweiten photosensitiven Schicht 3b durchgeführt werden. Die Photonen der zweiten Wellenlänge erreichen im Allgemeinen auch die erste photosensitive Schicht 3a, ohne dort eine chemische und/oder physikalische Reaktion zu erzeugen, die zu einer Belichtung des zweiten Tiefenbereichs 9a führt.

Die vergrößerte Darstellung zeigt einen vom DMD 7 in die photosensitive Schicht 3b projizierten Layoutabschnitt 10b. Die einzelnen Spiegel des DMD 7 wurden so geschaltet, dass beinahe alle Spiegel die Photonen mit einer zweiten Wellenlänge in die photosensitive Schicht 3b projiziert haben. Nur einige Spiegel, mit denen die Belichtung im oberen linken bzw. unteren rechten Bereich durchgeführt werden kann, wurden so geschaltet, dass die Photonen nicht in die photosensitive Schicht 3b projiziert wurden. Dadurch konnten erfindungsgemäße Bereiche geschaffen werden, die nach den späteren Ausheiz- und/oder Entwicklungsschritten Zugänge 13 in einem Deckel 12, bilden werden, um die Außenwelt mit der Kavität 11 (siehe vorherige Figur) zu verbinden.

Die **Figur 1f** zeigt einen achten Verfahrensschritt des ersten erfindungsgemäßen Verfahrens, bei dem es zu einer Relativbewegung zwischen dem Substrat 1 und dem optischen System 4 zu einer zweiten Position kommt. Die Verfahrensschritte aus den Figuren 1d-1f können nun für beliebig viele Positionen wiederholt werden.

Nach diesen Verfahrensschritten erfolgen weitere Prozessschritte, insbesondere die Entwicklung des Beschichtungssystems 3. Vorteilhaft wird nur ein einziger Entwicklungsschritt benötig.

Durch die Figuren könnte der Eindruck entstehen es handle sich bei dem erfindungsgemäßen Verfahren um einen Step-and-Repeat Prozess, mit dessen Hilfe mindestens eine dreidimensionale Struktur, bestehend aus der Kavität 11, einem Deckel 13 und den Zugängen 12, an einer oder mehrerer Stellen im Schichtsystems 3 auf dem Substrat 1 erzeugt werden soll. Obwohl das erfindungsgemäße Verfahren sehr wohl dafür geeignet wäre, das optische System 4 relativ zum Substrat 1 an einer ersten Position zu positionieren um dort eine solche dreidimensionale Struktur zu erzeugen, um danach mehrere weitere Relativbewegungen zu mehreren weiteren Position durchzuführen um weitere dreidimensionale Strukturen zu erzeugen, kann man damit viel mehr bewirken.

Insbesondere dann, wenn die zu erzeugenden dreidimensionalen Strukturen größer sind als das Belichtungsraster des DMD 7 selbst, müssen die dreidimensionalen Strukturen während der Relativbewegung zwischen dem optischen System 4 und dem Substrat 1 durch kontinuierliche Programmierung der Spiegel des DMD während der Relativbewegung belichtet werden. Die Anwendung einer Photonenquelle 5 und eines Schichtsystems 3 ist insbesondere unter dem Aspekt einer solchen kontinuierlichen Relativbewegung und eines kontinuierlichen Schaltvorgangs der Spiegel des DMDs 7 zu betrachten.

Ein alternatives erfindungsgemäßes Verfahren, das auf einer Maskentechnologie basiert, wird im Folgenden beschrieben.

Die Figuren 1a bis 1b können ebenfalls für das zweite erfindungsgemäße Verfahren verwendet werden und werden nicht nochmals dargestellt.

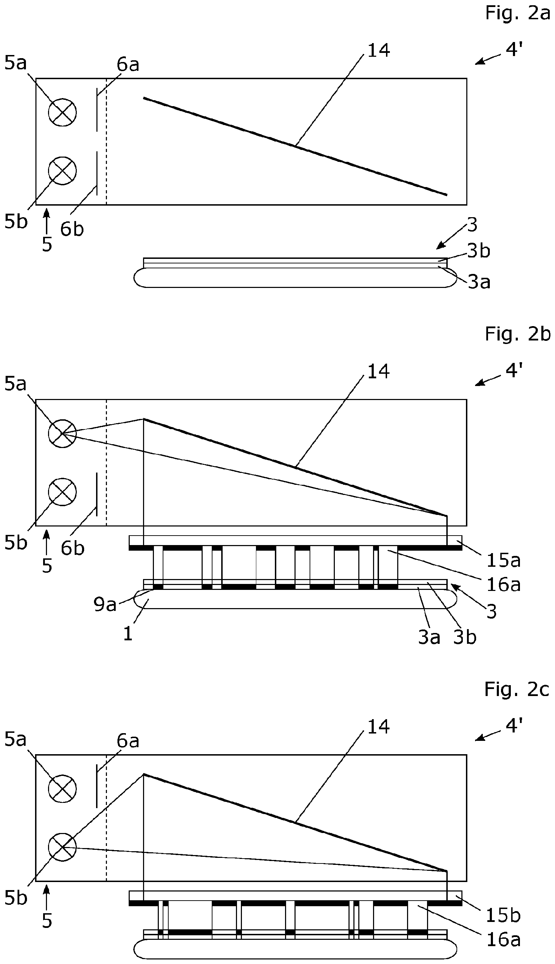

Die **Figur 2a** zeigt einen dritten und vierten Verfahrensschritt eines zweiten erfindungsgemäßen Verfahrens, bei dem ein Substrat 1 mit einer Beschichtung 3 in einen Maskenbelichter geladen wird. Der Maskenbelichter verfügt wiederum über ein optisches System 4`, das für eine Flächenbelichtung ausgelegt ist. Insbesondere können optische Elemente wie ein Spiegel, vorzugsweise ein Kaltspiegel, 14 vorgesehen sein, die die Photonen in Richtung Substrat 1 reflektieren. Die Vorrichtung verfügt über eine Photonenquelle 5 mit mindestens zwei einzelnen Photonenquellen 5a, 5b, sowie über die Filter 6a, 6b. Aussagen zu den einzelnen Photonenquellen 5a, 5b und den Filtern 6a,6b aus den vorherigen Textabschnitten gelten analog.

Die **Figur 2b** zeigt einen fünften Verfahrensschritt des zweiten erfindungsgemäßen Verfahrens, bei dem eine erste Maske 15a mit ersten Aperturen 16a zwischen das optische System 4` und das Substrat 1 eingefügt werden. Die erste Maske 15a wird insbesondere relativ zum Substrat 1 ausgerichtet, vorzugsweise durch Ausrichtungsmarken (nicht eingezeichnet). Es wird der Filter 6a (nicht eingezeichnet) geöffnet bzw. entfernt bzw. der zweite Filter 6b geschlossen gehalten. Dadurch treten Photonen mit einer ersten Wellenlänge aus der ersten einzelnen Photonenquelle 5a aus und werden durch Aperturen 16a der ersten Maske 15a auf die Beschichtung 3 projiziert. Da nur die erste photosensitive Schicht 3a des Schichtsystems 3 sensitiv für die Photonen der ersten Wellenlänge der ersten einzelnen Photonenquelle 5a ist, finden die chemischen und/oder physikalischen Reaktionen nur in den ersten belichteten Tiefenbereiche 9a statt, obwohl die Photonen auch die zweite photosensitive Schicht 3b durchdringen.

Die **Figur 2c** zeigt einen sechsten, siebten und achten Verfahrensschritt eines zweiten erfindungsgemäßen Verfahrens, bei dem zuerst die erste Maske 15a (nicht eingezeichnet) gegen die zweite Maske 15b ausgetauscht wurde. Die zweite Maske 15b verfügt über zweite Aperturen 16b. Die zweite Maske 15b wird insbesondere relativ zum Substrat 1 ausgerichtet, vorzugsweise durch Ausrichtungsmarken (nicht eingezeichnet). Erfindungsgemäß wird der Filter 6b (nicht eingezeichnet) geöffnet bzw. entfernt bzw. der zweite Filter 6a geschlossen gehalten. Dadurch treten Photonen mit einer zweiten Wellenlänge aus der zweiten einzelnen Photonenquelle 5b aus und werden durch Aperturen 16b der zweiten Maske 15b, auf die Beschichtung 3 projiziert. Da nur die zweite photosensitive Schicht 3b des Schichtsystems 3 sensitiv für die Photonen der zweiten Wellenlänge der zweiten einzelnen Photonenquelle 5b ist, finden die chemischen und/oder physikalischen Reaktionen auch nur in den zweiten belichteten Tiefenbereiche 9b statt, obwohl die Photonen auch die erste photosensitive Schicht 3a erreichen.

Nach diesen Verfahrensschritten erfolgen weitere Prozessschritte, insbesondere die Entwicklung des Beschichtungssystems 3. Vorteilhaft wird nur ein einziger Entwicklungsschritt benötig.

### Bezugszeichenliste

- 1: Substrat
- 2: Beschichtungssystem
- 2a, 2b: Einzelnes Beschichtungselement
- 3: Beschichtung
- 3a, 3b: Bereiche/Photosensitive Schichten
- 4, 4`: Optisches System
- 5: Strahlungseinrichtung, Photonenquelle
- 5a, 5b: Einzelne Photonenquellen
- 6a, 6b: Filter
- 7: digitale Mikrospiegeleinheit, Digital Micromirror Device (DMD)
- 8a, 8b: Sekundärstrahlen
- 9a, 9b: Belichteter Tiefenbereich
- 10a, 10b: Layoutabschnitt
- 11: Kavität
- 12: Deckel
- 13: Zugänge
- 14: Spiegel
- 15a, 15b: Maske
- 16a, 16b: Aperturen

## Patentansprüche

1. Verfahren zur Belichtung einer photosensitiven Beschichtung (3), aufweisend mindestens einen ersten photosensitiven Bereich (3a) und einen zweiten photosensitiven Bereich (3b), wobei der erste Bereich (3a) auf Photonen einer ersten Wellenlänge reagiert und der zweite Bereich (3b) auf Photonen einer zweiten Wellenlänge reagiert, wobei die erste Wellenlänge von der zweiten Wellenlänge verschieden ist, wobei das Verfahren die folgenden Schritte, insbesondere den folgenden Ablauf, aufweist:
- Belichtung der Beschichtung (3) mit den Photonen der ersten Wellenlänge,
- Belichtung der Beschichtung (3) mit den Photonen der zweiten Wellenlänge,
**dadurch gekennzeichnet, dass** keine Fokussierung der Photonen auf die photosensitiven Bereiche (3a,3b) erfolgt.

2. Verfahren gemäß Anspruch 1, wobei die Beschichtung (3) durch eine dynamisch steuerbare Einrichtung, insbesondere durch eine digitale Mikrospiegeleinheit (7), belichtet wird.

3. Verfahren gemäß mindestens einem der vorhergehenden Ansprüche, wobei die Beschichtung (3) durch mindestens eine Maske (15a, 15b) belichtet wird.

4. Verfahren gemäß mindestens einem der vorhergehenden Ansprüche, wobei die Belichtung der Beschichtung (3) mit den Photonen der ersten Wellenlänge nur im ersten Bereich (3a) eine photochemische Reaktion erzeugt und die Belichtung der Beschichtung (3) mit den Photonen der zweiten Wellenlänge nur im zweiten Bereich (3b) eine photochemische Reaktion erzeugt.

5. Verfahren gemäß mindestens einem der vorhergehenden Ansprüche, wobei die Beschichtung (3) ortsaufgelöst und/oder punktweise, insbesondere mittels Strahlenbündeln, belichtet wird.

6. Verfahren gemäß mindestens einem der vorhergehenden Ansprüche, wobei die Beschichtung (3) durch eine individuell steuerbare Photonenquelle (5) belichtet wird, wobei die Wellenlänge und/oder die Dosis der Photonen eingestellt wird/werden.

7. Verfahren gemäß mindestens einem der vorhergehenden Ansprüche, wobei die Beschichtung (3) durch Einstellung eines Filters (6a,6b) vor einer breitbandigen Photonenquelle (5) belichtet wird, wobei die Wellenlänge und/oder die Dosis eingestellt wird/werden.

8. Verfahren gemäß mindestens einem der vorhergehenden Ansprüche, wobei nacheinander unterschiedliche Tiefenbereiche der Beschichtung (3) reagieren.

9. Verfahren gemäß mindestens einem der vorhergehenden Ansprüche, wobei die Beschichtung (3) über eine Dicke der Beschichtung (3) variierende Empfindlichkeiten für Photonen gleicher Wellenlänge aufweist.

10. Verfahren gemäß mindestens einem der vorhergehenden Ansprüche, wobei der erste Bereich (3a) als eine erste Schicht ausgebildet wird und der zweite Bereich (3b) als eine zweite Schicht auf der ersten Schicht ausgebildet wird.

11. Vorrichtung zur Belichtung einer photosensitiven Beschichtung (3), aufweisend mindestens einen ersten photosensitiven Bereich (3a) und einen zweiten photosensitiven Bereich (3b), wobei der erste photosensitive Bereich (3a) auf Photonen einer ersten Wellenlänge reagiert und der zweite photosensitive Bereich (3b) auf Photonen einer zweiten Wellenlänge reagiert, wobei die erste Wellenlänge von der zweiten Wellenlänge verschieden ist, aufweisend eine Strahlungseinrichtung (5) zur Belichtung der Beschichtung (3) mit den Photonen der ersten Wellenlänge und zur Belichtung der Beschichtung (3) mit den Photonen der zweiten Wellenlänge,
**dadurch gekennzeichnet, dass** die Vorrichtung derart konfiguriert ist,
dass keine Fokussierung der Photonen auf die photosensitiven Bereiche (3a,3b) erfolgt.

12. Vorrichtung gemäß Anspruch 11, aufweisend eine dynamisch steuerbare Einrichtung, insbesondere eine digitale Mikrospiegeleinheit (7), zur Belichtung der Beschichtung (3).

13. Vorrichtung gemäß mindestens einem der vorhergehenden Ansprüche, aufweisend mindestens eine Maske (15a, 15b) zur Belichtung der Beschichtung (3).

14. Vorrichtung gemäß mindestens einem der vorhergehenden Ansprüche, aufweisend eine bewegliche Halterung zur Bewegung der Beschichtung (3) gegenüber der Strahlungseinrichtung (5).

## Claims

1. A method for the exposure of a photosensitive coating (3), comprising at least a first photosensitive area (3a) and a second photosensitive area (3b), wherein the first area (3a) reacts to photons of a first wavelength and the second area (3b) reacts to photons of a second wavelength, wherein the first wavelength is different from the second wavelength, wherein the method comprises the following steps, in particular the following sequence:
- exposure of the coating (3) with the photons of the first wavelength,
- exposure of the coating (3) with the photons of the second wavelength,
**characterised in that** no focusing of the photons takes place on the photosensitive areas (3a, 3b).

2. The method according to claim 1, wherein the coating (3) is exposed by a dynamically controllable device, in particular by a digital micromirror unit (7).

3. The method according to at least one of the preceding claims, wherein the coating (3) is exposed by means of at least one mask (15a, 15b).

4. The method according to at least one of the preceding claims, wherein the exposure of the coating (3) with the photons of the first wavelength produces a photochemical reaction only in the first area (3a) and the exposure of the coating (3) with the photons of the second wavelength produces a photochemical reaction only in the second area (3b).

5. The method according to at least one of the preceding claims, wherein the coating (3) is exposed spatially resolved and/or pointwise, in particular by means of beam bundles.

6. The method according to at least one of the preceding claims, wherein the coating (3) is exposed by an individually controllable photon source (5), wherein the wavelength and/or the dose of the photons is/are adjusted.

7. The method according to at least one of the preceding claims, wherein the coating (3) is exposed by the adjustment of a filter (6a, 6b) in front of a broadband photon source (5), wherein the wavelength and/or the dose is/are adjusted.

8. The method according to at least one of the preceding claims, wherein different depth regions of the coating (3) react one after the other.

9. The method according to at least one of the preceding claims, wherein the coating (3) has varying sensitivities for photons of the same wavelength over the thickness of the coating (3).

10. The method according to at least one of the preceding claims, wherein the first area (3a) is constituted as a first layer and the second area (3b) is constituted as a second layer on the first layer.

11. A device for the exposure of a photosensitive coating (3), comprising at least a first photosensitive area (3a) and a second photosensitive area (3b), wherein the first area (3a) reacts to photons of a first wavelength and the second area (3b) reacts to photons of a second wavelength, wherein the first wavelength is different from the second wavelength, comprising a radiation device (5) for the exposure of the coating (3) with the photons of the first wavelength and for exposure of the coating (3) with the photons of the second wavelength,
**characterised in that** the device is configured such that no focusing of the photons takes place on the photosensitive areas (3a, 3b).

12. The device according to claim 11, comprising a dynamically controllable device, in particular a micromirror unit (7), for the exposure of the coating (3).

13. The device according to at least one of the preceding claims, comprising at least one mask (15a, 15b) for the exposure of the coating (3).

14. The device according to at least one of the preceding claims, comprising a movable holder for the movement of the coating (3) with respect to the radiation device (5).

## Revendications

1. Procédé d'exposition d'un revêtement photosensible (3), présentant au moins une première zone photosensible (3a) et une seconde zone photosensible (3b), dans lequel la première zone (3a) réagit à des photons d'une première longueur d'ondes, et la seconde zone (3b) réagit à des photons d'une seconde longueur d'ondes, dans lequel la première longueur d'ondes est différente de la seconde longueur d'ondes, dans lequel le procédé présente les étapes suivantes, en particulier le déroulement suivant :
- exposition du revêtement (3) aux photons de la première longueur d'ondes,
- exposition du revêtement (3) aux photons de la seconde longueur d'ondes,
**caractérisé en ce qu'**il ne se produit aucune focalisation des photons sur les zones photosensibles (3a, 3b).

2. Procédé selon la revendication 1, dans lequel le revêtement (3) est exposé par un dispositif pouvant être commandé de façon dynamique, en particulier par une unité de micro-miroir numérique (7).

3. Procédé selon au moins l'une des revendications précédentes, dans lequel le revêtement (3) est exposé par au moins un masque (15a, 15b).

4. Procédé selon au moins l'une ou plusieurs des revendications précédentes, dans lequel l'exposition du revêtement (3) aux photons de la première longueur d'ondes produit une réaction photochimique uniquement dans la première zone (3a) et l'exposition du revêtement (3) aux photons de la seconde longueur d'ondes produit une réaction photochimique uniquement dans la seconde zone (3b).

5. Procédé selon au moins l'une ou plusieurs des revendications précédentes, dans lequel le revêtement (3) est exposé en étant dissout localement et/ou ponctuellement, en particulier au moyen de faisceaux de rayons.

6. Procédé selon au moins l'une ou plusieurs des revendications précédentes, dans lequel le revêtement (3) est exposé par une source de photons (5) pouvant être commandée individuellement, dans lequel la longueur d'ondes et/ou la dose des photons est/sont réglée(s).

7. Procédé selon au moins l'une ou plusieurs des revendications précédentes, dans lequel le revêtement (3) est exposé par réglage d'un filtre (6a, 6b) devant une source de photons (5) à large bande, dans lequel la longueur d'ondes et/la dose est/sont réglée(s).

8. Procédé selon au moins l'une ou plusieurs des revendications précédentes, dans lequel différentes zones de profondeurs l'une après l'autre du revêtement (3) réagissent.

9. Procédé selon au moins l'une ou plusieurs des revendications précédentes, dans lequel le revêtement (3) présente des sensibilités qui varient aux photons de longueur d'onde égale sur une épaisseur du revêtement (3).

10. Procédé selon au moins l'une ou plusieurs des revendications précédentes, dans lequel la première zone (3a) est formée en tant qu'une première couche, et la seconde zone (3b) est formée en tant qu'une seconde couche sur la première couche.

11. Dispositif d'exposition d'un revêtement photosensible (3), présentant au moins une première zone photosensible (3a) et une seconde zone photosensible (3b), dans lequel la première zone photosensible (3a) réagit à des photons d'une première longueur d'ondes, et la seconde zone photosensible (3b) réagit à des photons d'une seconde longueur d'ondes, dans lequel la première longueur d'ondes est différente de la seconde longueur d'ondes, présentant un dispositif de rayonnement (5) pour exposer le revêtement (3) aux photons de la première longueur d'ondes et pour exposer le revêtement (3) aux photons de la seconde longueur d'ondes,
**caractérisé en ce que** le dispositif est ainsi configuré qu'il ne se produit aucune focalisation des photons sur les zones photosensibles (3a, 3b).

12. Dispositif selon la revendication 11, présentant un dispositif pouvant être commandé de façon dynamique, en particulier par une unité de micro-miroir numérique (7), pour exposer le revêtement (3).

13. Dispositif selon au moins l'une des revendications précédentes, présentant au moins un masque (15a, 15b) pour exposer le revêtement (3).

14. Dispositif selon au moins l'une des revendications précédentes, présentant une fixation mobile pour déplacer le revêtement (3) par rapport au dispositif de rayonnement (5).
